# EUROPEAN PATENT SPECIFICATION

(11) **EP 1 719 164 B1**
(45) Date of publication and mention of the grant of the patent: **28.07.2010**
(21) Application number: 05702944.9
(22) Date of filing: 10.02.2005
(51) Int. Cl.: H01L 21/336, H01L 21/265

(54) **METHOD OF MANUFACTURING A SEMICONDUCTOR DEVICE**
VERFAHREN ZUM HERSTELLEN EINES HALBLEITERBAUELEMENTS
PROCEDE DE FABRICATION D'UN DISPOSITIF SEMI-CONDUCTEUR

(30) Priority: 19.02.2004 EP 04100653
(43) Date of publication of application: 08.11.2006
(73) Proprietor: NXP B.V., 5656 AG Eindhoven (NL)
(72) Inventor: SURDEANU, Radu, C., NL-5656 AA Eindhoven (NL); DOORNBOS, Gerben, NL-5656 AA Eindhoven (NL); VAN DAL, Marcus, J., H., NL-5656 AA Eindhoven (NL)
(74) Representative: Schouten, Marcus Maria
(86) International application number: PCT/IB2005/050527
(87) International publication number: WO 2005/083769

(56) References cited:
- WO-A-02/075781
- WO-A-02/082503
- WO-A-2004/086491
- US-B1- 6 204 132
- US-B1- 6 242 776
- US-B1- 6 380 057
- US-B1- 6 465 847
- AUGENDRE E ET AL: "Thin L-shaped spacers for CMOS devices" EUROPEAN SOLID-STATE DEVICE RESEARCH, 2003 33RD CONFERENCE ON. ESSDERC '03 SEPT. 16-18, 2003, PISCATAWAY, NJ, USA,IEEE, 16 September 2003 (2003-09-16), pages 219-222, XP010676643 ISBN: 0-7803-7999-4
- EROKHIN Y N ET AL: "SPATIALLY CONFINED NICKEL DISILICIDE FORMATION AT 400 DEG C ON ION IMPLANTATION PREAMORPHIZED SILICON" APPLIED PHYSICS LETTERS, AMERICAN INSTITUTE OF PHYSICS. NEW YORK, US, vol. 63, no. 23, 6 December 1993 (1993-12-06), pages 3173-3175, XP000414077 ISSN: 0003-6951

## Description

The invention relates to a method of manufacturing a semiconductor device in accordance with claim 1.

A semiconductor device is known from United States patent specification US 6,465,847 B1. Said semiconductor device comprises a semi conductive substrate layer; an insulating layer formed on the substrate layer; a semi conductive active region formed on the insulating layer, said active region comprising a source, a drain and a body between said source and said drain. The semiconductor device further comprises a gate formed on the body in such a manner that the gate, the source, the drain and the body together form a transistor. The above-mentioned, known semiconductor device further comprises at least one silicide region at the location of the source or drain. The silicide is formed, for example, from the metal titanium. The silicide extends under the side wall spacer for maximally 10 nm.

A drawback of the known semiconductor device resides in that the series resistance of the diffusion regions (source and drain) is high. This adversely affects the operation of the semiconductor device.

A method of manufacturing the semiconductor device of the type set forth in the opening paragraph is known from United States patent specification US 6,465,874 B1. The method comprises the following steps:
- providing a semiconductor body comprising a substrate layer, an active layer and a buried oxide layer in between the substrate layer and the active layer;
- forming a gate on the semiconductor body, the gate comprising a dielectric layer and a conductive layer;
- forming a side wall spacer on either side of the gate;
- forming source and drain regions on either side of the gate;
- carrying out an amorphization implantation in order to form a layer of amorphous silicon at the location of the source or drain regions;
- forming silicide regions at the location of the source or drain regions.

A drawback of the known method resides in that the series resistance of the diffusion regions of the semiconductor device is high. This adversely affects the operation of the semiconductor device.

It is an object of the invention to provide a method of the type mentioned in the opening paragraph, by means of which the series resistance of the diffusion regions can be reduced.

To achieve this, a method is provided, comprising the steps of:
- providing a silicon-containing semiconductor body (110) having a surface (126) which is provided with a gate (170);
- forming a L-shaped side wall spacer (136, 138) on either side of the gate (170, 270), the side wall spacer comprising a first portion, which borders on the gate and extends substantially perpendicularly with respect to the surface of the semiconductor body, and a second portion, which extends along the surface of the semiconductor body;
- forming a diffusion region (180, 182) in the semiconductor body (110, 210) on either side of the gate (170);
- carrying out an amorphization implantation (116) to render the silicon of the semiconductor body (110) amorphous at the surface (126) of the diffusion regions (180, 182, 280) for forming amorphous regions (189,191,193,195), the dimensions of the side wall spacers (136, 138) and the implantation parameters chosen such that the amorphous regions (189,191,193,195) extend to below the side wall spacers (136, 138) over a distance beyond 10 nm, and
- converting the amorphous regions (189,191,193,195) into a silicide (190,192,194,196) via interaction with a metal (118) which has a higher diffusion rate in the silicide (190, 192) formed than silicon.

This method has the advantage that the silicide is formed so as to extend under the side wall spacer over a distance beyond 10 nm. As a result, the series resistance of the diffusion regions will be reduced.

WO 02/075781 A2 discloses a transistor, comprising a semiconducting substrate, a gate insulation layer positioned above the substrate, a gate electrode positioned above the gate insulation layer, a plurality of source/drain regions formed in the substrate, a first and a second sidewall spacer positioned adjacent the gate electrode, and a metal silicide layer formed above each of the source/drain regions, a portion of the metal silicide layer being positioned adjacent the first sidewall spacer and under the second sidewall spacer. The method comprises forming a transistor by forming a gate insulation layer and a gate electrode above a semiconducting substrate, forming a first sidewall spacer adjacent the gate electrode, forming a metal silicide layer adjacent the first sidewall spacer and above previously formed implant regions in the substrate, forming a second sidewall spacer above a portion of the metal silicide layer and adjacent the first sidewall spacer, and forming additional metal silicide material above the metal silicide layer extending beyond the second sidewall spacer.

US 6,204,132 B1 discloses a method of forming a silicide layer using an angled pre-amorphization implant.

An embodiment of the method in accordance with the invention is **characterized in that** for the conversion of the silicon that has been rendered amorphous into a silicide, use is made of a metal selected from the group comprising: nickel (Ni), platinum (Pt) and palladium (Pd). Alloys of these metals are suitable too. These metals are advantageous because of their comparatively high diffusion rate in silicide when compared to silicon.

An embodiment of the method in accordance with the invention is **characterized in that** the amorphization implantation is carried out in the direction of the substrate, the smallest one of the two angles with respect to the normal to the surface of the semiconductor body (also referred to as implantation angle) being larger than 0 degrees. By means of this oblique implantation, it is achieved that the silicon under the side wall spacers is also amorphized. As a result, the silicide will be formed over a larger distance under the side wall spacers.

In the method in accordance with the invention to the side wall spacer is formed so as to be L-shaped. The L-shaped side wall spacer has the advantage that it becomes possible to control the dimensions of the amorphous region under the side wall spacer. As a result, the silicide will be formed over a longer distance under the side wall spacers.

The second portion of the L-shaped side wall spacer is preferably formed in a thickness, measured in a direction perpendicular to the surface of the semiconductor body, of maximally 40 nm.

These and other aspects of the invention as well as the method of manufacturing the semiconductor device in accordance with the invention will be explained in greater detail with reference to the drawings, in which:
Fig. 1 is a diagrammatic cross-sectional view of a known semiconductor device;
Fig. 2 is a diagrammatic cross-sectional view of an embodiment of the semiconductor device in accordance with the invention;
Figs. 3 through 10 are diagrammatic cross-sectional views of the semiconductor device in different stages of the manufacturing process;
Fig. 11 shows an advantage of L-shaped side wall spacers in combination with oblique amorphization implantation;
Fig. 12 shows the silicide growth process, using rapidly diffusing metals;
Fig. 13 shows an embodiment of the device wherein traditional side wall spacers are combined with oblique amorphization implantation. Fig. 13 does not form part of the invention.

The Figures are not drawn to scale but are merely for illustration purposes.

Like reference numerals refer to like parts. Alternative embodiments are possible within the scope of protection of the claims.

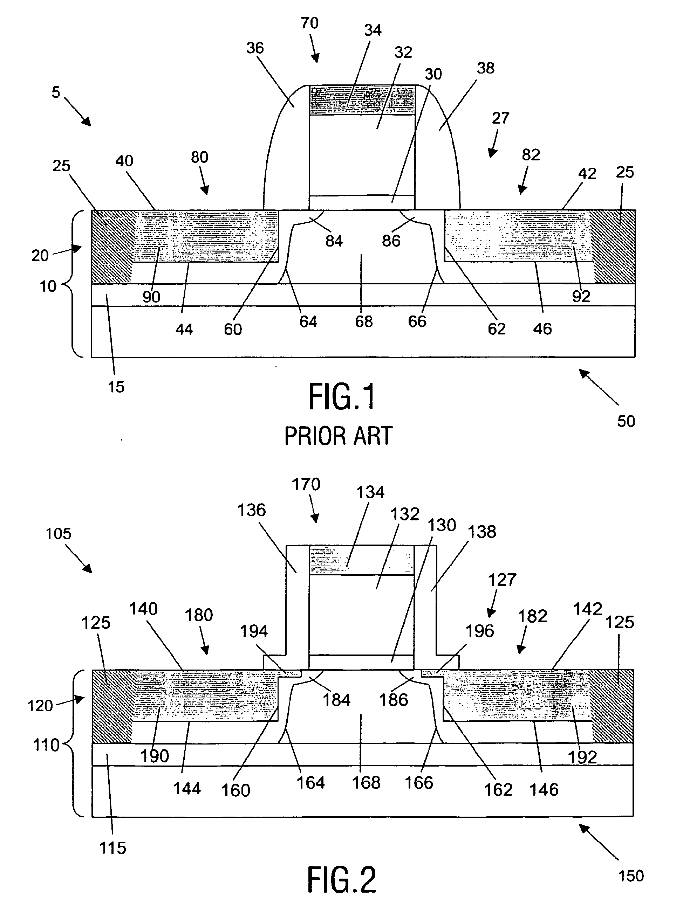

Fig. 1 diagrammatically shows a cross-sectional view of a semiconductor device 5 as disclosed in United States patent specification US 6,465,847 B1. The semiconductor device 5 comprises a silicon-containing semiconductor body 10 comprising an oxide layer 15 and an active layer 20. These three layers jointly form an SOI substrate 50. In the active layer there are provided: insulating regions 25 (made of, for example, silicon oxide) and an active region 27. Said active region 27 comprises a source 80 and a drain 82. These are also referred to as diffusion regions. In the present description, these terms will be used interchangeably. The active region 27 further comprises a body 68. The source 80 and drain 82 also comprise source and drain extensions 84, 86. On the active layer 20 there is further provided an insulating layer 30 (made of, for example, silicon oxide) and a gate 70. Said gate 70 comprises a conductive layer 32 (made of, for example, polycrystalline silicon) and a silicide layer 34 (made of titanium silicide). A side wall spacer 36, 38 is present on either side of the gate 70. The source 80 comprises a silicide region 90, which generally has a lateral interface 44 and a vertical interface 60 with the source 80. The source 80 has a junction 64 with the body 68. The drain 82 comprises a silicide region 92, which in general has a lateral interface 46 and a vertical interface 62 with the drain 82. The drain 82 has a junction 66 with the body 68.

The silicide regions 90, 92 have surfaces 40, 42 on which electrical connections can be formed at a later stage. For this purpose use is generally made of vias, contact holes and conducting wires. For the sake of clarity, these components have been omitted and will also be omitted later on in the description.

A characteristic of the silicide regions 90, 92 is that, in the known device, they continue for maximally 10 nm under the side wall spacers 36, 38. It is known that this silicide under the side wall spacers 36, 38 has a favorable effect on the operation of the semiconductor device 5, because this silicide causes the series resistance of the source 80 and drain 82 to be reduced. However, in general, it is desired to create a safe distance between the silicide boundary surfaces 60, 62 and the junctions 64, 66 with the body 68, because too small a distance may lead to a large leakage current through these junctions 64, 66.

Fig. 2 is a diagrammatic cross-sectional view of an embodiment of the semiconductor device 105 in accordance with the invention. The semiconductor device 105 comprises a silicon-containing semiconductor body 110 comprising an oxide layer 115 and an active layer 120. These three layers jointly form a SOI substrate 150. The SOI substrate is used only to illustrate the invention. Other substrates are alternatively possible. In the active layer there are provided: insulating regions 125 (made of, for example, silicon oxide) and an active region 127. The active region 127 comprises a source 180 and a drain 182. These are also referred to as diffusion regions. The active region 127 additionally comprises a body 168. The source 180 and drain 182 also comprise source and drain extensions 184, 186. On the active layer 120 there is further provided an insulating layer 130 (made of, for example, silicon oxide) and a gate 170. Said gate 170 comprises a conductive layer 132 (made of, for example, polycrystalline silicon) and a silicide layer 134. If the conductive layer 132 is made of a metal, the silicide layer 134 will be absent. An L-shaped side wall spacer 136, 138 is present on either side of the gate 170. The source 180 comprises a silicide region 190 which, in general, has a lateral interface 144 and a vertical interface 160 with the source 180. The source 180 has a junction 164 with the body 168. The drain 182 comprises a silicide region 192 which, in general, has a lateral interface 146 and a vertical interface 162 with the drain 182. The drain 182 has a junction 166 with the body 168.

The silicide regions 190, 192 have surfaces 140, 142 on which electrical connections can be formed at a later stage.

A characteristic of the silicide regions 190, 192 in the device in accordance with the invention is that they continue for a considerable distance under the side wall spacers 136, 138. These silicide regions 136, 138 have extensions 194, 196. These extensions 194, 196 are important because they reduce the series resistance of the diffusion regions 180, 182. As shown in this Figure, the reduction in resistance is achieved without reducing the distance between the silicide boundary faces 160, 162 and the junctions 164, 166. The silicide extensions 196, 196 fall within the source and drain extensions 184, 186, as a result of which there will be no leakage current through the junctions 164, 166 to the body 168.

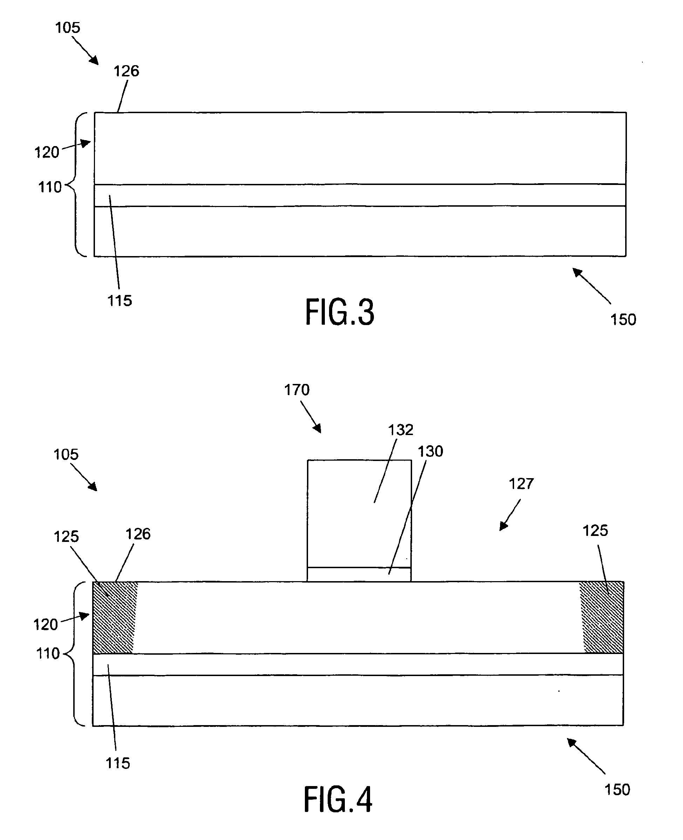

Fig. 3 is a diagrammatic cross-sectional view of the semiconductor device 105 in a stage of the manufacturing process. In this stage, a silicon-containing semiconductor body 110 is provided. In this embodiment, the substrate is a SOI substrate 150, but alternatively a different type of substrate may be used. The semiconductor body comprises an oxide layer 115 and an active layer 120. This silicon-containing semiconductor body 110 further comprises a surface 126.

Fig. 4 is a diagrammatic cross-sectional view of the semiconductor device 105 in a stage of the manufacturing process. In this stage, insulating regions 125 and an active region 127 are formed. On the active layer 120, an insulating layer 130 (made of, for example, silicon oxide) and a gate 170 are formed. The gate 170 comprises a conductive layer 132 (made of, for example, polycrystalline silicon).

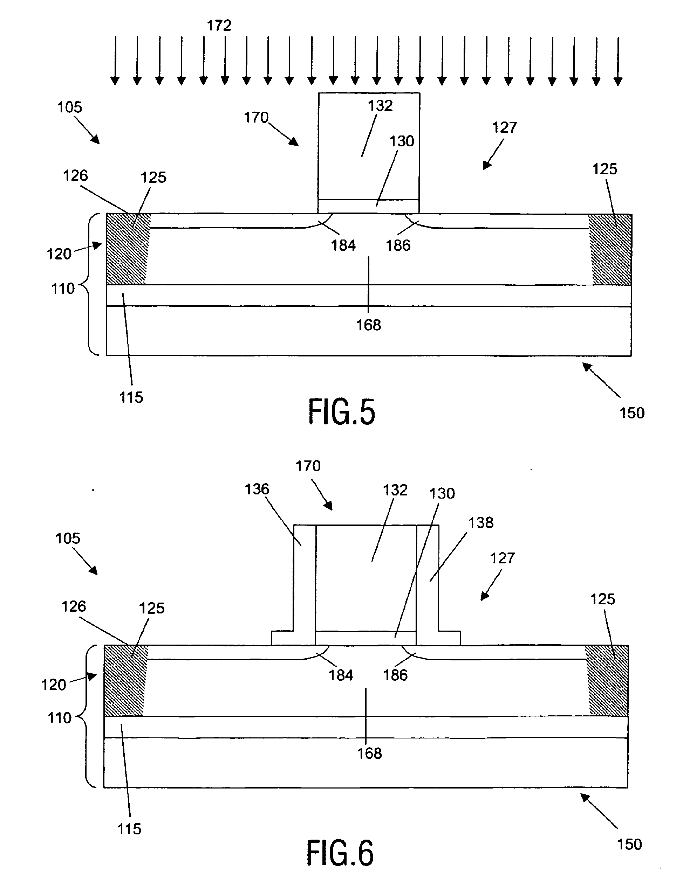

Fig. 5 is a diagrammatic cross-sectional view of the semiconductor device 105 in a stage of the manufacturing process. In this stage, the source and drain extensions 184, 186 are formed, which are also referred to as shallow implantation regions. For this purpose, use can be made of, for example, an ion implantation 172 using a lightly doped drain (LDD) technique. The ions which are suitable for this implantation step are inter alia phosphor (P), arsenic (As), antimony (Sb) or a combination of these ions, if the semiconductor device 105 is of the n-conductivity type (NMOS transistor). If the semiconductor device 105 is of the p-conductivity type (PMOS transistor), inter alia boron (B) may suitably be used. The implantation energy typically lies in the range of 0.1 keV to 80 keV, and the implantation dose typically lies in the range of 1 x 10¹² to approximately 5 x 10¹⁵ atoms/cm².

Besides implantation techniques, a solid phase epitaxy (SPE) technique may alternatively be used to form the source and drain extensions. This technique broadly comprises the following steps:
- amorphizing the silicon body, in which process amorphization implantation takes place in a self-aligned manner due to the presence of the gate 170;
- implantation doping, which also takes place in a self-aligned manner by virtue of the presence of the gate 170. Said doping may be of the p-conductivity type as well as of the n-conductivity type;
- recrystallizing the silicon by means of a low-temperature anneal step (approximately 700 °C).

Other methods of manufacturing source and drain extensions are, inter alia, plasma doping, plasma immersion and vapor phase doping. For more detailed information reference is made to United States patent specification US 6,465,847 B1.

Fig. 6 is a diagrammatic cross-sectional view of the semiconductor device 105 in a stage of the manufacturing process. In this stage, L-shaped side wall spacers 136, 138 are provided. For this purpose use can be made of various techniques. One of these techniques broadly comprises the following steps:
- providing a thin oxide layer over the gate 170;
- providing a thick nitride layer on top of the thin oxide layer;
- subjecting the nitride layer to a wet-chemical selective etch, thereby forming nitride spacers;
- dry-etching the thin oxide layer (for example by means of time-selective etching);
- selectively removing nitride by wet-chemical etching.

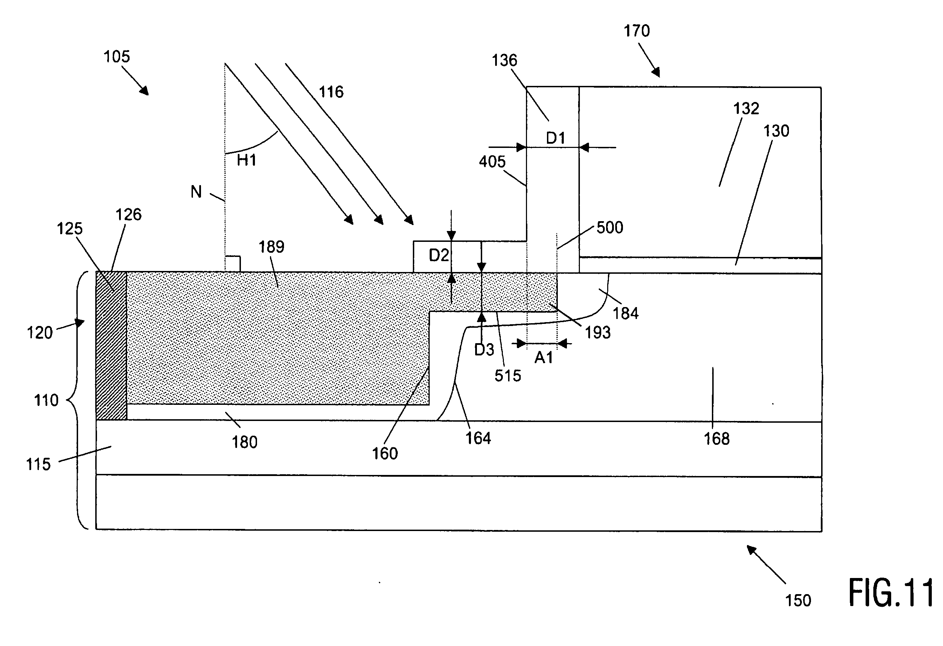

After said last step, L-shaped oxide spacers 136, 138 remain. The side wall spacers 136, 138 may thus be made of, inter alia, silicon oxide (SiO₂) or a silicon nitride (for example Si₃N₄), but other materials are also possible. At a later point in this description the L-shaped side wall spacers 136, 138 will be elucidated in more detail with reference to Fig. 11.

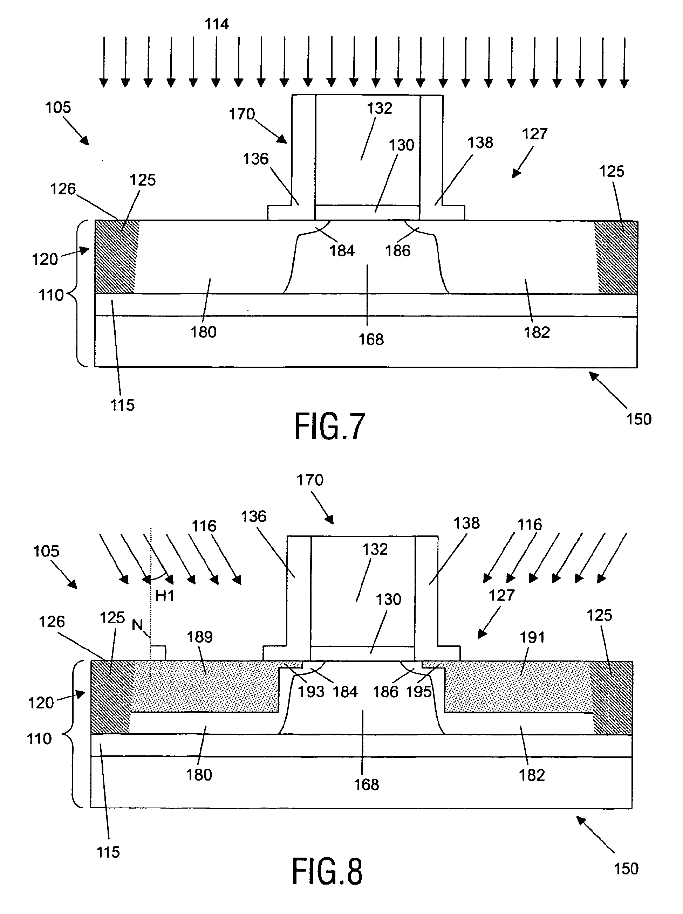

Fig. 7 is a diagrammatic cross-sectional view of the semiconductor device 105 in a stage of the manufacturing process. In this stage, deep implantation regions 180, 182 are formed. In this description these regions will hereinafter be referred to as source 180 and drain 182. The regions may be formed, for example, by means of a solid phase epitaxy (SPE) technique, as described hereinabove. Analogous to the formation of the source and drain extensions 184, 186, this process step requires an ion implantation 114. The ions suitable for this implantation step are, inter alia, phosphor (P) and arsenic (As) if the semiconductor device is of the n-conductivity type (NMOS transistor). If the semiconductor device is of the p-conductivity type (PMOS transistor) inter alia boron (B) can suitably be used. The implantation energy typically lies in the range of 0.1 keV to 100 keV, and the implantation dose typically lies in the range of 1 x 10¹⁴ to approximately 1 x 10¹⁶ atoms/cm². For more detailed information reference is made to United States patent specification US 6,465,847 B1.

Fig. 8 is a diagrammatic cross-sectional view of the semiconductor device 105 in a stage of the manufacturing process. In this stage, an amorphization implantation 116 is carried out. In this process, amorphous silicon regions 189, 191 are formed. These amorphous silicon regions 189, 191 also have extensions 193, 195 extending to below the side wall spacers 136, 138. At a later point in this description, this will be elucidated in more detail. By applying said amorphization implantation 116, the advantage is obtained that the silicide junctions yet to be formed will be defined more accurately and, in addition, the final contact resistance of the silicide will be lower.

In the amorphization implantation step, use is made of elements from the group comprising: xenon (Xe), argon (Ar), arsenic (As), antimony (Sb), indium (In), silicon (Si) and germanium (Ge). Those skilled in the art will readily find other elements or compounds that can suitably be used for this implantation. All of these variations fall within the scope of the invention. The implantation energy typically lies in the range of 0.1 keV to 100 keV, and the implantation dose typically lies in the range of 4 x 10¹³ to approximately 1 x 10¹⁶ atoms/cm².

During the amorphization implantation 116, also the conductive layer 132 is partly amorphized (this is not shown in the Figures for the sake of clarity). Amorphization of the conductive layer 132 may be precluded, if necessary, by the application of a so-termed capping layer on the gate (170).

The amorphization implantation 116 preferably takes place at an angle H1. Said angle H1 is defined with respect to the normal N to the surface 126 of the SOI substrate 150. As a result, the extensions 193, 195 will be formed over a larger distance under the side wall spacers 136, 138, which has a favorable effect on the formation of the silicide later on in the process. This aspect will be dealt with in more detail at a later point in the description.

Generally two orientations of the transistors on the semiconductor body 110 are possible, which are at right angles to each other. This is the reason why during the amorphization implantation 116, the SOI substrate 150 is rotated four times through 90 degrees, the aim being to amorphize the silicon under all side wall spacers 136, 138.

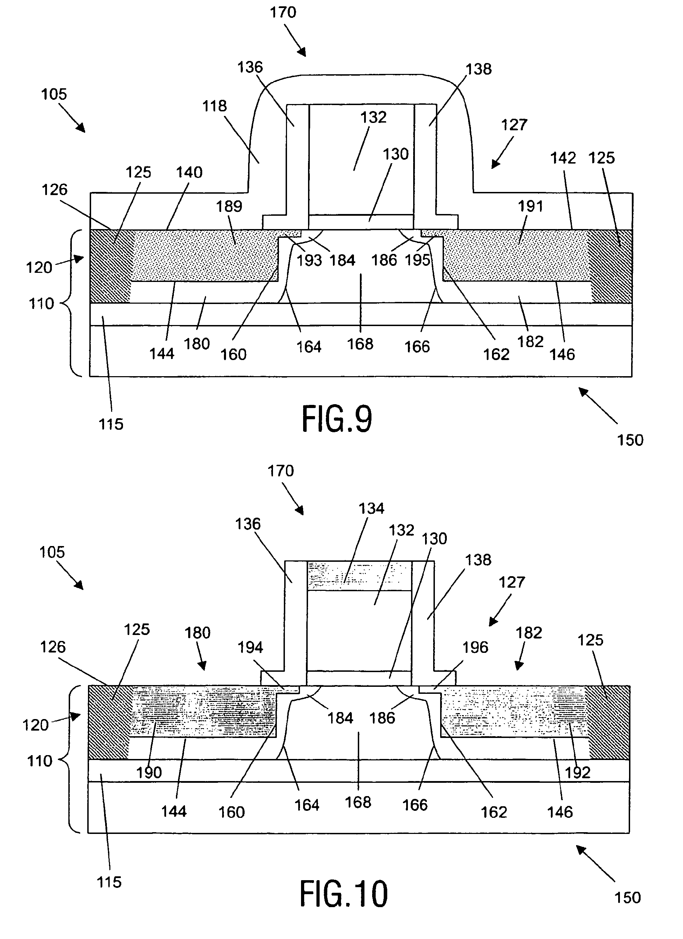

Fig. 9 is a diagrammatic cross-sectional view of the semiconductor device 105 in a stage of the manufacturing process. In this stage, a layer of metal 118 is provided on the source 180, the drain 182, the gate 170 and the side wall spacers 136, 138. Said metal 118 may be selected from the group comprising nickel (Ni), platinum (Pt) and palladium (Pd). Alloys of these metals are also possible.

Deposition of the metal layer 118 may take place by, for example, sputtering. The silicide regions 190, 192 (Fig. 10) can now be formed by reacting the metal 118 with the exposed surfaces 140, 142 of the source 180 and the drain 182. For this purpose use can be made of various silicidation techniques. Rapid Thermal Annealing (RTA) is one of the techniques that may be used. In rapid thermal annealing the temperature is increased for a short period of time (0 (fast spike)-120 seconds). This increased temperature typically ranges between 200 °C and 600 °C. Of course, other heating times and temperatures are possible.

The metal 118, which must eventually be converted into silicide, can diffuse through the amorphous silicon regions 189, 191 much more easily than through the crystalline silicon of the source 180 and the drain 182. The junctions 144, 146 form, as it were, a diffusion barrier to the metal 118. This accurate definition of the silicide regions 190, 192 (Fig. 10) is necessary to preclude that the silicide can extend beyond the junctions 164, 166 of the diffusion regions 180, 182. In that case, there would be a leakage current from the diffusion regions 180, 182 to the body 168.

The final product must be free of amorphous silicon. If it still contains amorphous silicon, this may lead to problems. Any remaining amorphous silicon can be removed by means of an additional anneal step.

Fig. 10 is a diagrammatic cross-sectional view of the semiconductor device 105 in a stage of the manufacturing process. In this stage, the silicide regions 190, 192, 134 are formed. In addition, the silicide has grown to below the side wall spacers 136, 138 in the form of extensions 194, 196. This growth is enhanced substantially if the metal 118 (Fig. 9) is chosen from the group comprising nickel (Ni), platinum (Pt) and palladium (Pd). Alloys of these metals are also possible. An important aspect in this case is that the metal/alloy in the silicide formed has a higher diffusion rate than silicon.

Persons skilled in the art may readily find more metals or metal compounds that have said property. All of these variations fall within the scope of the invention.

The extensions 194, 196 reduce the series resistance of the source 180 and drain 182 significantly, which substantially improves the operation of the semiconductor device.

Another aspect of the invention relates to the silicide being formed over a greater distance under the side wall spacers 136, 138 without an increase of the leakage current from the diffusion regions 180, 182 to the body 168. The extensions 194, 196 fall within the source and drain extensions 184, 186.

Fig. 11 illustrates an advantage of L-shaped side wall spacers 136, 138 in combination with oblique amorphization implantation. This Figure diagrammatically shows the semiconductor body 105 on an enlarged scale, at the location of the side wall spacer 136, in a stage of the manufacturing process. An important aspect of the invention is based on the fact that the extension of the amorphous region 193 is provided in a controlled manner, because this extension, in turn, determines the location of the silicide 194 at a later point in the manufacturing process.

The dimensions of the extension 193 can be accurately determined. The location of the boundary face 500 of the extension 193 is determined, notably, by the thickness D1 of the first portion of the side wall spacer 136 and the implantation angle H1. As the implantation always occurs in the direction of the substrate 150, the implantation angle H1 is the smallest one of the two angles with the normal N to the surface 126 of the semiconductor body 110.

The ions 116 are unable, measured in the direction perpendicular to the surface 126, to penetrate through the first portion of the side wall spacer 136. By way of illustration: implantation at right angles (i.e. the angle of implantation H1 is 0°) no amorphization will take place under the first portion of the side wall spacer 136 and hence (substantially) no silicide will be formed there at a later point in the process.

The thickness of the extension D3 depends on the thickness D2 of the second portion of the L-shaped side wall spacer 136 as well as on the implantation energy of the amorphization implantation 116 in combination with the angle of implantation H1. The thickness D2 of the L-shaped spacer 136 is preferably below 40 nm because otherwise the effect of the amorphization implantation 116 will be too low. In an embodiment of the semiconductor device 105 in accordance with the invention, the second portion has a thickness D2 of 5 to 20 nm.

The additional distance A1 over which the amorphous region extends with respect to the edge 405 of the first portion of the L-shaped side wall spacer 136 is determined notably by the implantation angle H1. As this angle H1 can be very accurately determined in the course of the manufacturing process, also the location of the boundary face 500 can be very accurately determined. The angle of implantation H1 can thus be used for fine tuning. The dimensions D1, D2 of the side wall spacer 136 can also be accurately determined during the manufacturing process. A person skilled in the art can thus use the parameters D1, D2 and H1 to accurately determine the location where the amorphization implantation ions should land and hence also the location where ultimately the silicide lands.

Another advantage of the L-shaped side wall spacer 136 resides in that, even in the case of implantation at an angle H1 unequal to 0°C, the interface 515 between the amorphous silicon and the crystalline silicon runs substantially parallel to the surface 126. If the side wall spacer has a traditional structure, this interface 515 will be obliquely positioned. If the implantation energy is too high, this interface may become positioned too close to, or even beyond, the junction 164, which may lead, after silicidation, to an undesirable leakage current from the diffusion regions 180, 182 to the body 168.

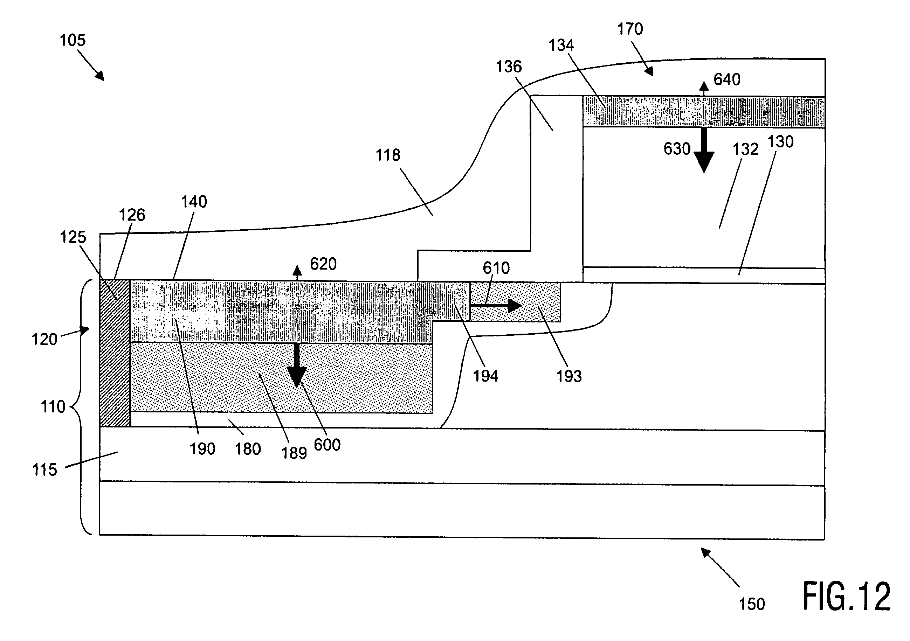

Fig. 12 illustrates the silicide growth process when use is made of rapidly diffusing metals. This Figure shows the semiconductor device 105 during the formation of the silicide 190. At this stage, the metal 118 is still on the source 180, the drain 182, the gate 170 and the side wall spacers 136, 138. The metal 118 is preferably selected from the group consisting of nickel (Ni), platinum (Pt) and palladium (Pd). Alloys of these metals are also possible. An important aspect here is that this metal or this alloy has a higher diffusion rate in the silicide 190 formed than silicon. As a result of this property, the rate of downward growth 600 of the silicide 190 will be substantially higher than the rate of upward growth 620. In addition, it is very important that also the growth rate 610 of the silicide extension 194 under the side wall spacer 136 is high, so that all of the amorphous silicon 193 is eventually converted to silicide 194. During the formation of the silicide 190, 194, the metal layer 118 is consumed. Any residue must be removed at a later stage in the manufacturing process. For this purpose use can be made of conventional techniques.

If, for example, nickel is used as the metal 118, the surface 140 will be slightly raised with respect to the surface 126 of the SOI substrate 150. By way of illustration: if nickel silicide is grown in a thickness of 22 nm, approximately 4 nm thereof will be situated above the surface 126 of the original semiconductor body 110.

In addition, a silicide layer 134 is formed on the gate 170. Also in this case the rate of downward growth 630 is higher than the rate of upward growth 640.

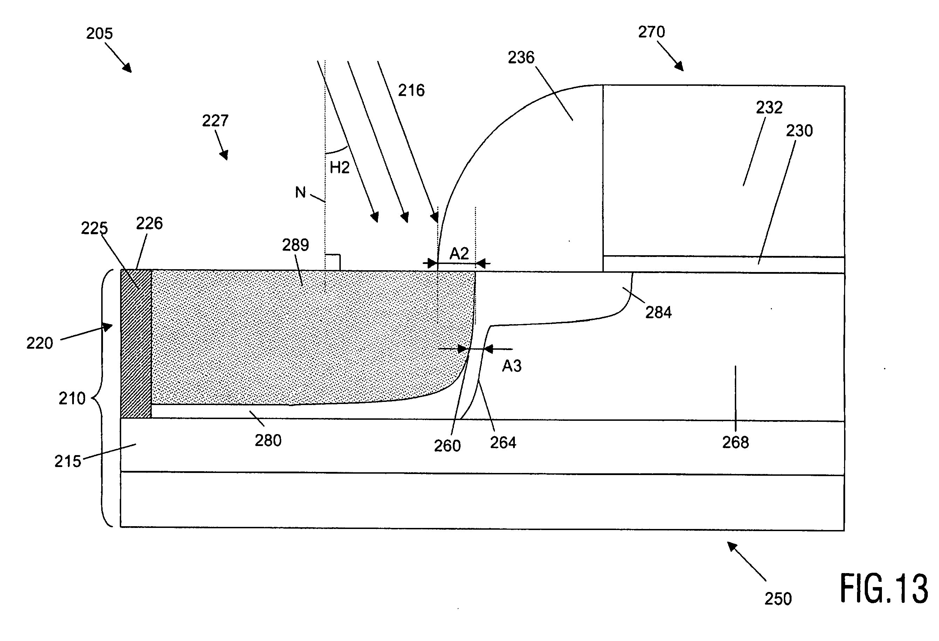

Fig. 13 illustrates, on an enlarged scale, a semiconductor device 205 with traditional side wall spacers 236 in combination with amorphization implantation 216 at an implantation angle H2. The method of manufacturing the semiconductor device 205 is in the amorphization implantation stage. This method does not form part of the invention.

Also in this case, by way of illustration, a SOI substrate 250 is provided which accommodates a silicon-containing semiconductor body 210 comprising an oxide layer 215 and an active layer 220. Insulating regions 225 and an active region 227 are also provided in the active layer 220. An insulating layer 230 (made of, for example, silicon oxide) and a gate 270 have already been formed on the active layer 220. This gate 270 comprises a conductive layer 232 (made of, for example, polycrystalline silicon). Also the side wall spacers 236, the shallow implantation regions 284 and the deep implantation regions 280 have already been formed.

Also in this case, the amorphization implantation takes place at an angle of implantation H2 which is greater than 0°. The angle of implantation H2 is the smallest one of the two angles with the normal N to the surface 226 of the SOI substrate 250. As a result, the amorphous region 289 will extend for a certain distance A2 under the side wall spacer 236. This distance A2 is larger than it would be if the angle of implantation H2 were equal to 0°. However, a certain distance A3 must be observed between the amorphous region and the junction 264, because otherwise the leakage current from the source 280 to the body 268 becomes too large. The maximum angle of implantation H2 thus is smaller than the maximum angle of implantation H1 (Fig. 11) in the case of L-shaped side wall spacers 136.

All Figures are diagrammatic and not drawn to scale. They serve to elucidate the the invention and the technical backgrounds thereof. In practice, the shapes of boundary faces/interfaces may be different from those shown in the Figures.

It is possible to manufacture a double or multiple gate architecture instead of a single gate architecture.

In addition, it is possible to fill the side wall spacers with, for example, nitride, so that they obtain a traditional shape again. This takes place after the amorphization implantation. Filling the side wall spacers has the advantage that the application of other layers (for example oxide layers) on top of the semiconductor device is made easier.

In the Figures use is made, by way of illustration, of SOI substrates, but the invention can also be applied to bulk substrates, strained-silicon substrates and substrates containing a germanium component.

## Claims

1. A method of manufacturing a semiconductor device (105) comprising the steps of:
- providing a silicon-containing semiconductor body (110) having a surface (126) which is provided with a gate (170);
- forming a L-shaped side wall spacer (136, 138) on either side of the gate (170), the side wall spacer comprising a first portion, which borders on the gate (170) and extends substantially perpendicularly with respect to the surface (126) of the semiconductor body (110), and a second portion, which extends along the surface (126) of the semiconductor body (110);
- forming a diffusion region (180, 182) in the semiconductor body (110) on either side of the gate (170);
- carrying out an amorphization implantation (116) to render the silicon of the semiconductor body (110) amorphous at the surface (126) of the diffusion regions (180, 182) for forming amorphous regions (189,191,193,195), the dimensions of the side wall spacers (136, 138) and the implantation parameters chosen such that the amorphous regions (189,191,193,195) extend to below the side wall spacers (136, 138) over a distance beyond 10 nm, and
- converting the amorphous regions (189,191,193,195) into a silicide (190, 192,194,196) via interaction with a metal (118) which has a higher diffusion rate in the silicide (190, 192) formed than silicon.

2. A method as claimed in claim 1, **characterized in that** the metal (118) is selected from the group comprising nickel (Ni), Platinum (Pt) and palladium (Pd), and alloys of these metals.

3. A method as claimed in claim 1, **characterized in that** the amorphization implantation angle (H1) is larger than 0 degrees.

4. A method as claimed in claim 1, **characterized in that** the second portion of the L-shaped side wall spacer (136, 138) is formed with a thickness (D2), measured in a direction perpendicular to the surface (126) of the semiconductor body (110), of maximally 40 nm.

5. A method as claimed in claim 4, **characterized in that** the second portion of the L-shaped side wall spacer (136, 138) is formed with a thickness (D2), measured in a direction perpendicular to the surface (126) of the semiconductor body (110), of between 5 and 20 nm.

6. A method as claimed in claim 1, **characterized in that** the semiconductor body (110) that is provided comprises an insulating layer (115) that extends in the semiconductor body (110) in a direction parallel to the surface (126) of the semiconductor body (110).

7. A method as claimed in claim 1, **characterized in that** the semiconductor body (110) that is provided comprises a germanium component.

8. A method as claimed in claim 1, **characterized in that** the semiconductor body (110) that is provided comprises a strained-silicon layer.

## Patentansprüche

1. Verfahren zur Herstellung einer Halbleitervorrichtung (105), die Schritte umfassend:
Bereitstellen eines Silizium enthaltenden Halbleiterkörpers (110), der eine Oberfläche (126) aufweist, die mit einem Gate (170) versehen ist;
Bilden eines L-förmigen Seitenwandabstandhalters (136, 138) auf jeder Seite des Gates (170), wobei der Seitenwandabstandhalter einen ersten Teil, der an das Gate (170) grenzt und sich im Wesentlichen senkrecht bezüglich der Oberfläche (126) des Halbleiterkörpers (110) erstreckt, sowie einen zweiten Teil umfasst, der sich längs der Oberfläche (126) des Halbleiterkörpers (110) erstreckt;
Bilden eines Diffusionsgebiets (180, 182) im Halbleiterkörper (110) auf beiden Seiten des Gates (170);
Ausführen einer Amorphisierungsimplantation (116), um das Silizium des Halbleiterkörpers (110) an der Oberfläche (126) der Diffusionsgebiete (180, 182) amorph zu machen, um amorphe Gebiete (189, 191, 193, 195) zu bilden, wobei die Abmessungen der Seitenwandabstandhalter (136, 138) und die Implantationsparameter so gewählt werden, dass sich die amorphen Gebiete (189, 191, 193, 195) bis unterhalb der Seitenwandabstandhalter (136, 138) über eine Strecke von 10 nm hinaus erstrecken, und
Umwandeln der amorphen Gebiete (189, 191, 193, 195) in ein Silizid (190, 192, 194, 196) durch Wechselwirkung mit einem Metall (118), das eine höhere Diffusionsrate im gebildeten Silizid (190, 192) aufweist als Silizium.

2. Verfahren nach Anspruch 1, **dadurch gekennzeichnet, dass** das Metall (118) aus einer Gruppe ausgewählt ist, die Nickel (Ni), Platin (Pt) und Palladium (Pd), sowie Legierungen dieser Metalle umfasst.

3. Verfahren nach Anspruch 1, **dadurch gekennzeichnet, dass** der Amorphisierungsimplantationswinkel (H1) größer als 0 Grad ist.

4. Verfahren nach Anspruch 1, **dadurch gekennzeichnet, dass** der zweite Teil des L-förmigen Seitenwandabstandhalters (136, 138), gemessen in einer Richtung senkrecht zur Oberfläche (126) des Halbleiterkörpers (110), mit einer Dicke (D2) von maximal 40 nm ausgebildet ist.

5. Verfahren nach Anspruch 4, **dadurch gekennzeichnet, dass** der zweite Teil des L-förmigen Seitenwandabstandhalters (136, 138), gemessen in einer Richtung senkrecht zur Oberfläche (126) des Halbleiterkörpers (110), mit einer Dicke (D2) zwischen 5 und 20 nm ausgebildet ist.

6. Verfahren nach Anspruch 1, **dadurch gekennzeichnet, dass** der Halbleiterkörper (110), der bereitgestellt wird, eine Isolationsschicht (115) aufweist, die sich im Halbleiterköper (110) in einer Richtung parallel zu der Oberfläche (126) des Halbleiterkörpers (110) erstreckt.

7. Verfahren nach Anspruch 1, **dadurch gekennzeichnet, dass** der Halbleiterkörper (110), der bereitgestellt wird, eine Germaniumkomponente umfasst.

8. Verfahren nach Anspruch 1, **dadurch gekennzeichnet, dass** der Halbleiterkörper (110), der bereitgestellt wird, eine Schicht aus gestrecktem Silizium umfasst.

## Revendications

1. Procédé de fabrication d'un dispositif à semi-conducteur (105) comportant les étapes suivantes :
- fourniture d'un corps de semi-conducteur contenant du silicium (110) ayant une surface (126) qui est munie d'une grille (170) ;
- formation d'un espaceur de paroi latérale en forme de L (136, 138) sur chacun des côtés de la grille (170), l'espaceur de paroi latérale comprenant une première partie, qui jouxte la grille (170) et s'étend substantiellement perpendiculairement par rapport à la surface (126) du corps de semi-conducteur (110), et une deuxième partie qui s'étend le long de la surface (126) du corps de semi-conducteur (110) ;
- formation d'une région de diffusion (180, 182) dans le corps de semi-conducteur (110), de chaque côté de la grille (170) ;
- réalisation d'une implantation d'amorphisation (116) pour rendre le silicium du corps de semi-conducteur (110) amorphe sur la surface (126) des régions de diffusion (180, 182) de manière à former des régions amorphes (189, 191, 193, 195), les dimensions des espaceurs de parois latérales (136, 138) et les paramètres d'implantation étant choisis de telle sorte que les régions amorphes (189, 191, 193, 195) s'étendent sous les espaceurs de parois latérales (136, 138) sur une distance allant au-delà de 10 nm, et
- conversion des régions amorphes (189, 191, 193, 195) en siliciure (190, 192, 194, 196) par interaction avec un métal (118) qui a une vitesse de diffusion plus élevée dans le siliciure formé (190, 192) que dans le silicium.

2. Procédé selon la revendication 1, **caractérisé par le fait que** le métal (118) est choisi parmi le groupe comprenant le nickel (Ni), le platine (Pt) et le palladium (Pd) et les alliages de ces métaux.

3. Procédé selon la revendication 1, **caractérisé par le fait que** l'angle d'implantation de l'amorphisation (H1) est supérieur à 0 degré.

4. Procédé selon la revendication 1, **caractérisé par le fait que** la deuxième partie de l'espaceur de parois latérales en forme de L (136, 138) est formée avec une épaisseur (D2) de 40 nm au maximum, mesurée dans une direction perpendiculaire à la surface (126) du corps de semi-conducteur (110).

5. Procédé selon la revendication 4, **caractérisé par le fait que** la deuxième partie de l'espaceur de parois latérales en forme de L (136, 138) est formée avec une épaisseur (D2), mesurée dans une direction perpendiculaire à la surface (126) du corps de semi-conducteur (110), comprise entre 5 et 20 nm.

6. Procédé selon la revendication 1, **caractérisé par le fait que** le corps de semi-conducteur (110) qui est fourni comporte une couche isolante (115) qui s'étend dans le corps de semi-conducteur (110) dans une direction parallèle à la surface (126) du corps de semi-conducteur (110).

7. Procédé selon la revendication 1, **caractérisé par le fait que** le corps de semi-conducteur (110) qui est fourni comporte un composant de germanium.

8. Procédé selon la revendication 1, **caractérisé par le fait que** le corps de semi-conducteur (110) qui est fourni comporte une couche de silicium contrainte.
